# EUROPEAN PATENT SPECIFICATION

(11) **EP 4 302 042 B1**
(45) Date of publication and mention of the grant of the patent: **12.06.2024**
(21) Application number: 22712045.8
(22) Date of filing: 28.02.2022
(51) Int. Cl.: F28D 15/02, F28F 3/12, H05K 7/20, H01L 23/427, F28F 13/06, F28F 9/02, F28D 21/00, H01L 23/367

(54) **MICRO-CHANNEL HEAT EXCHANGER**
WÄRMETAUSCHER MIT MIKROKANÄLEN
ÉCHANGEUR DE CHALEUR À MICRO-CANAUX

(30) Priority: 02.03.2021 IT 202100004793
(43) Date of publication of application: 10.01.2024
(73) Proprietor: Wieland Provides S.r.l., 04100 Latina (LT) (IT)
(72) Inventor: PROVENZIANI, Franco, 04100 Latina LT (IT); CATALDO, Filippo, 04100 Latina LT (IT)
(74) Representative: Papa, Elisabetta
(86) International application number: PCT/IB2022/051737
(87) International publication number: WO 2022/185177

(56) References cited:
- WO-A1-2016/069380
- AU-A1- 2015 339 755
- AU-A1- 2015 339 759
- US-B1- 10 048 024
- THOMPSON S M ET AL: "Investigation of a flat-plate oscillating heat pipe with Tesla-type check valves", EXPERIMENTAL THERMAL AND FLUID SCIENCE, ELSEVIER, AMSTERDAM, NL, vol. 35, no. 7, 22 April 2011 (2011-04-22) , pages 1265-1273, XP028254597, ISSN: 0894-1777, DOI: 10.1016/J.EXPTHERMFLUSCI.2011.04.014 [retrieved on 2011-04-30]

## Description

### Technical field of the invention

The present invention relates to a heat exchanger, in particular to an evaporator of the so-called "micro-channel" type and operating with a two-phase fluid.

The invention evaporator is specifically suitable for use as device for cooling processing units, power electronics and/or data centres and it is configured to solve the typical instabilities associated to the use of an evaporating two-phase flow.

### Background

More and more attention is currently paid to the heat exchange systems using two-phase fluids since they offer high performances in terms of heat transfer coefficients and heat load transportation capability.

In the field of electronics, and with reference to the systems for cooling electronic apparatuses, two-phase fluid heat exchangers result to be particularly interesting both for the applications on small scale (for example CPU of a personal computer) and for large-scale systems, that is data centre.

However, such solutions have some known drawbacks, thereamong mainly a flow instability of the two-phase fluid so as to influence negatively the performances of the heat exchange system which, in some cases, can jeopardize the operating continuity or even damage the electronic apparatus thereto this system is associated.

Such flow instabilities can be classified as static, that is they cause a change in the operating conditions, constant over time, or dynamic, or which cause continuous changes in time between two or more operating conditions, and detectable both at the level of device (exchanger) and of system, such as for example in case of pump circuits and especially in thermosyphons).

In the applications on small scale, the just described problem is particularly felt in the field of the heat exchangers, in particular in the so-called "micro-channel" evaporators. A micro-channel evaporator according to the preamble of claim 1 is disclosed in document WO 2016/069380 A1.

As it is known in the field, the micro-channel exchangers are characterized in that the heat carrier fluid crossing it is indeed confined within paths - or channels - having sizes in the order of the millimetre or lower.

The instabilities of a two-phase fluid in a micro-channel exchanger can be severe. In summary, such instabilities derive from the two-phase nature of the fluid, in particular from the different behaviour of the liquid phase/steam inside said channels. The instabilities can involve for example quick and uncontrolled increases in the temperature of the exchange wall and/or determine a bad distribution of pressure/fluid flow rate in continuous fluctuation between the inlet/outlet manifolds and the channels themselves.

It is not uncommon that the instabilities (and relative effects) of different origin are present at the same time (and the superimposed effects) in the same exchanger, by making complex to plan exchangers immune from such problem. In order to solve the instabilities generated by a flow of two-phase fluid in a micro-channel evaporator it was proposed to adopt orifices/restrictions at the inlet in the channels in order to encourage a preferential way of crossing the fluid. However, high pressure drops and the risk of steam formation already in the manifold region do not make such solution sufficiently suitable, especially in the thermosyphon circuits.

In other cases, it was proposed to introduce pressure losses localized upstream and/or downstream of the exchanger, to provide inletting expansion vessels and/or to modify the geometry of the channels so that they have a divergent development.

Even in these cases the known solutions represent a compromise which does not solve wholly the above-described problem.

### Summary of the invention

The technical problem placed and solved by the present invention then is to provide a heat exchanger of the micro-channel type, in particular an evaporator, allowing to obviate one or more of the drawbacks mentioned above with reference to the known art.

Such problem is solved by an evaporator according to claim 1.

Preferred features of the present invention are set forth in the depending claims.

In the present context, the term "micro-channels" associated to the expression "heat exchanger" or "evaporator" identifies a type of heat exchanger known to the person skilled in the art of the heat exchangers, or an exchanger wherein, in use, the heat carrier fluid crossing the heat exchange region results to be confined in paths having hydraulic diameter in the order of millimetre or lower.

The heat exchanger of the invention is a heat exchanger of the micro-channel type and it is suitable for cooling electronic components.

Said exchanger in particular is an evaporator and comprises a plate-like body having an external coupling surface with the electronic component to be cooled. The plate-like body internally carries an inlet manifold for a two-phase cooling fluid and an outlet manifold for said fluid downstream of the heat exchange.

The inlet manifold and the outlet manifold are in fluid communication by means of a heat exchange chamber placed inside the plate-like body, at said coupling surface.

The above-mentioned inlet manifold and outlet manifold are also in fluid communication by means of unidirectional circulation means of the cooling fluid, housed in the plate-like body and configured to allow circulation of the liquid phase of the fluid exclusively from the outlet manifold towards the inlet manifold.

It will be appreciated that such solution advantageously allows to provide an evaporator of the micro-channel type working at high performances by in full safety since a planning is not required so as to obtain the ideal conditions of a steam title equal to 1 outgoing from the heat exchange chamber (and then with the risk of instabilities due to critical heat flow conditions).

That is, it is possible to recover the liquid phase of the fluid downstream of the heat exchange and to send it from the outlet manifold to the inlet one by means of dedicated means of forced circulation. In this way, even if the outlet manifold houses steam with a title lower than one, the liquid phase is separated from the steam phase, but it does not return against the flow in the exchange chamber, on the contrary it re-circulates in said camera in the provided operation direction, that is by returning to the inlet manifold to cross again the chamber and reach the outlet manifold.

In other words, it is possible to confine the dynamic instabilities of a two-phase flow to improve the heat exchange and optimize the performances of the latter.

Still, the invention provides a micro-channel evaporator and two-phase fluid which in front of a known "passive" operation, especially in applications providing thermosyphons or pulsating heat devices, carries inside thereof means for controlling circulation of the fluid flow, allowing an "autonomous" control of circulation in case of instability.

In a preferred embodiment, the unidirectional circulation means comprises a Tesla valve. However, any other type of static unidirectional valve is however applicable.

Advantageously, then it is possible to obtain an effective solution by means of implementing a non-return valve with reduced overall dimension, with a simple construction and reliable, at least since it has no movable mechanical components required for its operation.

Other advantages, features and use modes of the present invention will result evident from the following detailed description of some embodiments, shown by way of example and not for limitative purposes.

### Brief description of figures

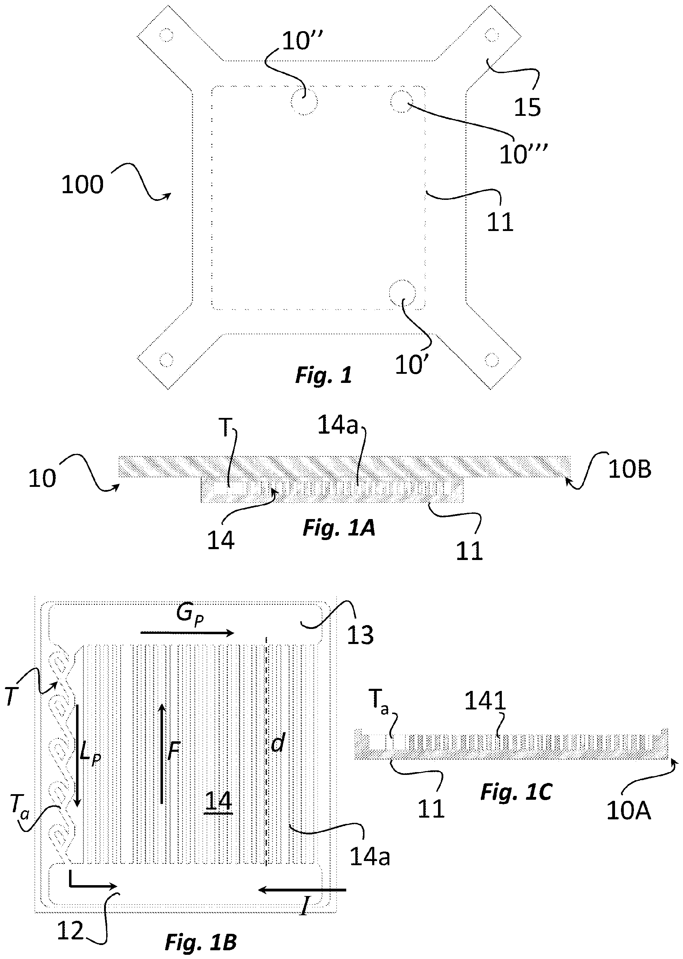

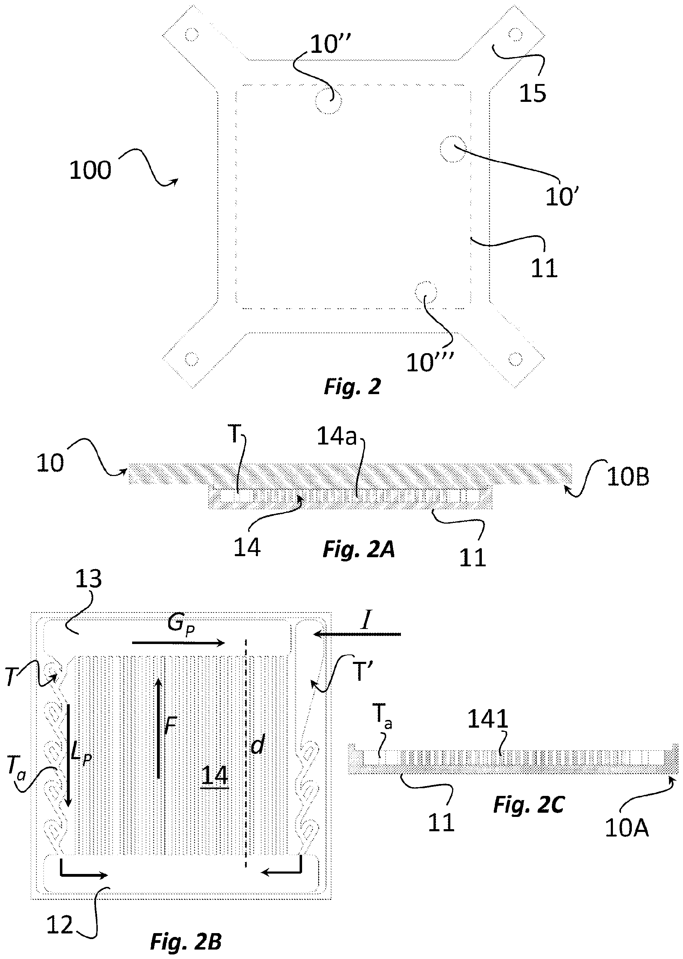

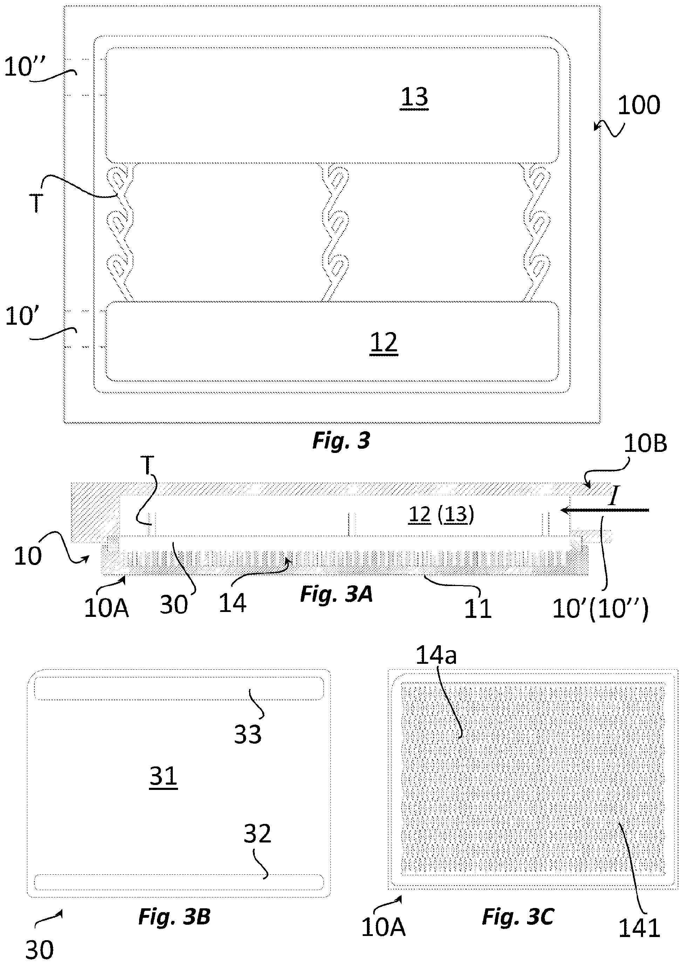

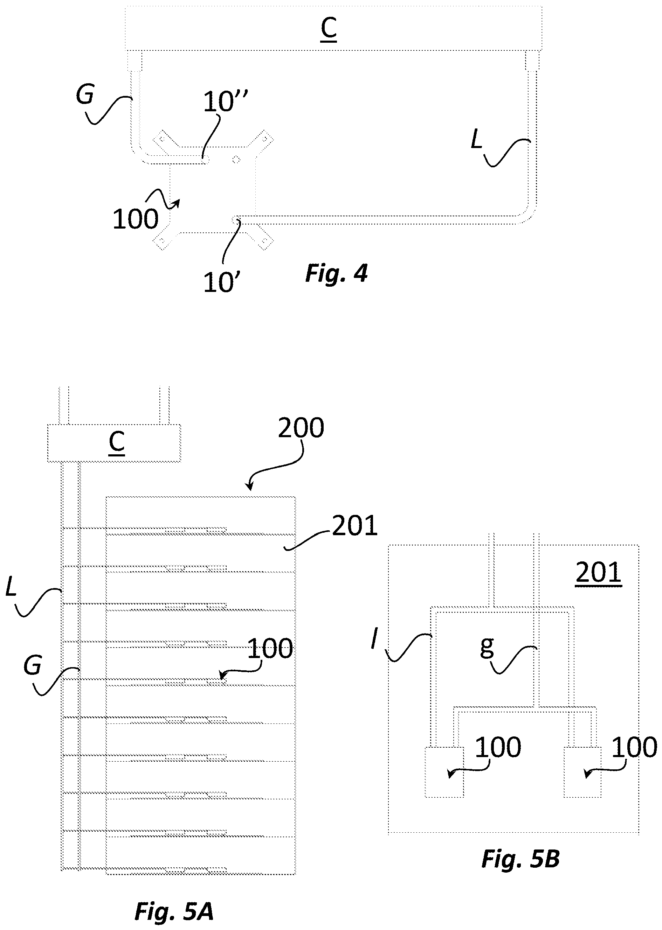

The figures of the enclosed drawings will be referred to, wherein:
▪ Figures 1 and 1A show schematic views, a top view and a cross section view respectively, of a first embodiment of a heat exchanger according to the present invention;
▪ Figures 1B and 1C show a top view and a corresponding cross section view of a component of the exchanger illustrated in Figures 1 and 1A, respectively;
▪ Figures 2 and 2A show schematic views, a top view and a cross section view respectively, of a second embodiment of a heat exchanger according to the present invention;
▪ Figures 2B and 2C show a top view and a corresponding a cross section view of a component of the exchanger illustrated in Figures 2 and 2A, respectively;
▪ Figures 3 and 3A show schematic views, a top view and a cross section view respectively, of a third embodiment of a heat exchanger according to the present invention;
▪ Figures 3B and 3C show top views of a first and a second component of the exchanger illustrated in Figures 3 and 3A, respectively;
▪ Figure 4 shows a schematic view of a preferred application of the exchanger of the invention according to the first or the second embodiment;
▪ Figures 5A and 5B show a schematic side view of a preferred application of the exchanger of the invention according to the third embodiment and a schematic top view of a detail of Figure 5A, respectively.

### Detailed description of preferred embodiments

By firstly referring to Figure 1, 1A-1C a heat exchanger according to the present invention is shown, designated as a whole with reference 100 and implemented according to a first embodiment.

The exchanger 100 of the invention is a heat exchanger of the so-called "micro-channel" type suitable for use in association to electronic systems such as for example processing units, power electronics and data centres.

In particular, the heat exchanger of the invention is used as evaporator and results to be suitable for cooling electronic components or however for a use in apparatuses for cooling electronic systems, such as for example cooling apparatuses of thermosyphon type.

The heat exchanger - or evaporator - 100 comprises a main body 10 having a substantially plate-like overall dimension. An external surface 11 of the plate-like body 10 is provided for coupling with the (not shown) electronic component to be cooled.

Preferably, said coupling surface 11 is planar and the plate-like body 10 has a substantially quadrilateral geometry. In embodiments, said surface 11 is configured for a thermal coupling with the electronic component by means of an interface material, for example thermal paste or tablets.

According to each one of the embodiments of the herein described heat exchanger, the plate-like body 10 can include anchoring means, for example projections designated in Figures 1 and 2 with reference 15, for the coupling with the electronic component to be cooled.

In general terms, the plate-like body 10 internally carries an inlet manifold 12 suitable to receive a two-phase cooling fluid and an outlet manifold 13 for said fluid downstream of the heat exchange.

Preferably, the exchanger 100 uses a cooling fluid of the type commercially designated as R1234ze(E) or R1233zd(E). Both of them are zero GWP fluids, and suitable to evaporation at normal temperatures. The invention is suitable particularly to the fluid R1233zd(E), since, for its thermophysical properties, it is subjected to strong instabilities in micro-channel exchangers without the invention configuration.

The plate-like body 10 then comprises an inlet port 10' for the fluid inlet in the inlet manifold 12 and an outlet port 10" for the fluid outlet from the outlet manifold 13. An additional opening 10‴ for (re)charging the cooling fluid inside the exchanger can be provided.

The inlet 12 and outlet 13 manifolds are in fluid communication by means of a heat exchange chamber 14 placed inside the plate-like body 10 and positioned at the coupling surface 11.

In a preferred embodiment of the invention, the heat exchange chamber 14 comprises inside thereof flow channels 14a wherein said motion of the cooling fluid is confined. Said flow channels 14a put in fluid communication the inlet manifold 12 and the outlet manifold 13.

With reference to a quadrilateral geometry of the plate-like body 10 as mentioned above, the inlet manifold 12 and the outlet manifold 13 are positioned preferably along opposite perimeter edges of the plate-like body 10.

Said flow channels 14a preferably extend along respective prevalent directions of development d parallel to each other. Depending upon the type of application or of the adopted embodiment, the flow channels 14a can be obtained by means of a metal foam structure or be implemented as a plurality of ribs, preferably in form of fins 141 as it can be seen, for example, in Figures 1A-1C. The flow channels 14a preferably have a hydraulic diameter comprised between 0.2 millimetres (mm) and 1.0 millimetre (mm).

Preferably, the inlet 12 and outlet 13 manifolds have a prevalent direction of development orthogonal, or substantially orthogonal, to the development direction d of the flow channels 14a.

According to the first embodiment, and as it can be seen in Figure 1B, the inlet manifold 12 and the outlet manifold 13 are further in fluid communication by means of unidirectional circulation means for the cooling fluid, designated with reference T.

Said unidirectional circulation means T is housed in the plate-like body 10 and is configured to allow circulation of the liquid phase of the cooling fluid exclusively from the outlet manifold 13 towards said inlet manifold 12.

The fluid crossing direction in the heat exchange chamber 14 is shown in Figure 1B with the arrow F. The crossing direction of the liquid phase of the cooling fluid in the unidirectional circulation means T is shown in Figure 1B with the arrow *L_{P}*.

Figure 1B further shows the inlet direction I of the fluid in the inlet manifold 12 and the outlet direction G_{P} of the steam phase from the outlet manifold 13.

Under operating conditions, the inlet fluid *I* in the exchanger tends to flow from the inlet manifold 12 crossing the heat exchange chamber 14, towards the outlet manifold 13 but without being able to travel the unidirectional circulation means T which is oriented in the direction of maximum resistance to the flow coming from the inlet manifold 12.

Due to the instabilities of the cooling fluid flow and in case the pressure difference between the inlet 12 and outlet 13 manifolds is negative, the fluid liquid phase *L_{P}* accumulated in the outlet manifold 13 recirculates towards the inlet manifold 12 by crossing the unidirectional circulation means T which is oriented in the direction of less resistance to the fluid flow coming from the outlet manifold 13.

It is appropriate to note that recirculation of the liquid phase *L_{P}* from the outlet manifold 13 towards the inlet manifold 12 takes place only and only if an instability phenomenon in the exchanger 100 occurs. In other words, if and only if the static pressure value in the outlet manifold 13 exceeds the static pressure value in the inlet manifold 12 (instability condition), the unidirectional circulation means T activates and a positive depression restores between the inlet manifold 12 and the outlet one 13.

This process of (re)equilibrium of pressures in the manifolds 12, 13 can be static (that is, it takes place only once over time, in case of static instability) or continuous over time (in case of dynamic instability).

As previously mentioned, the instabilities due to the two-phase mixture of the fluid then are advantageously exploited to allow recirculation of the liquid phase *L_{P}* not evaporated inside the exchanger.

A first advantageous effect is to obtain a higher quality (title) of steam exiting the exchanger 100, by reducing the pressure drop in the internal two-phase circuit of the exchanger itself.

With reference to an application of the exchanger in a complex cooling system, it is possible to further solve the instabilities indeed at the system level since the instabilities at the exchanger level can reproduce between the two manifolds 12, 13 without any repercussion on the remaining portion of the cooling system itself.

Moreover, recirculation of the liquid phase *L_{P}* allows a kind or pulsating motion of the cooling fluid in the heat exchange chamber 14. It was demonstrated with experimental data that the pulsating motion is more effective than the conventional unidirectional motion of a flow of two-phase fluid, since the liquid film in the heat exchange chamber 14, in particular on the walls of the flow channels 14a, is thinner.

Moreover, the pulsating motion favours the reintegration of the liquid on the wall of the channels 14a wherein it dries up, by allowing effectively to the evaporator to work safely, far from the critical heat conditions.

Preferably, the unidirectional circulation means T comprises a fluidic diode, for example a non-return valve, and advantageously it is positioned outside the heat exchange chamber 14, but however inside the plate-like body 10. In this way, a correct operation of the unidirectional circulation means T is guaranteed, which means does not result to be conditioned by the behaviour of the fluid which exchanges heat.

Independently from the embodiment of the invention, the above-described unidirectional circulation means *T* preferably comprises a so-called Tesla valve. However, any other type of static unidirectional valve is however applicable.

Such device, as known to the person skilled in the art, preferably comprises second flow channels Tₐ allowing the fluid to flow preferentially inside thereof in a direction and to prevent it from flowing in the opposite direction, advantageously without providing movable components for its operation.

The second flow channels Tₐ can include loops and recesses shaped so that the fluid crossing direction results to be substantially parallel to the development direction d of the flow channels 14a of the heat exchange chamber 14.

It will be appreciated that such solution even allows to integrate in a micro-channel exchanger means for controlling fluid circulation having a structure with compact overall dimensions and it is characterized by structural simplicity and low costs.

With particular reference to Figures 1B and 1C, the plate-like body 10 of the exchanger 100 can be formed by a base plate 10A and a cover element 10B coupled together, for example reversibly to allow an inspection of the heat exchange chamber 14. According to preferred embodiments, the base plate 10A and the cover element 10B are welded to each other.

The coupling surface 11 preferably corresponds to an external surface of said base plate 10A and preferably it extends for a width at least equal to the planar extension of the heat exchange chamber 14.

Advantageously, the flow channels 14a of the exchange chamber 14 and/or the second flow channels Tₐ of the unidirectional circulation means T remain defined by the coupling of the base plate 10A and the cover element 10B.

Additionally, in the first embodiment of the exchanger of the invention, it can be seen that the heat exchange chamber 14 results to be interposed between the inlet manifold 12 and the outlet manifold 13. Such solution offers advantages in terms of reduced vertical overall dimensions of the exchanger 100.

A second embodiment of the exchanger will be now described, with reference to Figures 2, 2A-2B and by dwelling on the distinctive features with respect to the first above-illustrated embodiment.

In this case, second unidirectional circulation means T' is housed in the plate-like body 10 and configured so as to prevent circulation of the cooling fluid from said inlet manifold 12 towards the inlet port 10' of the fluid in the exchanger.

Advantageously, the selected positioning of the second unidirectional circulation means T' prevents the liquid phase *L_{P}* of fluid, recirculated from the outlet manifold 13 in the inlet manifold 12, from flowing towards the inlet port 10'. Such drawback, in fact, could take place after a pressure increase in the inlet manifold 12 by causing the fluid to flow by means of the inlet port 10' instead of crossing the heat exchange chamber 14.

Substantially, the liquid phase *L_{P}* of cooling fluid present in the inlet manifold 12 is then forced to cross the heat exchange chamber 14. In this way also the risk of generating steam in the inlet manifold 12 itself is reduced.

In relation to the structural modes and type of the second unidirectional circulation means T' the same considerations illustrated for the unidirectional circulation means T with reference to the first embodiment can be valid.

Figures 3, 3A-3C illustrate a third embodiment of the micro-channel exchanger of the invention. According to such variant, the heat exchange chamber 14 and the unidirectional circulation means T are mutually superimposed on each other. Such arrangement offers advantages in terms of reduced side overall dimensions of the exchanger.

In the illustrated example, the unidirectional circulation means T comprises three Tesla valves spaced apart parallel to each other. Embodiment variants can provide a different number of valves and/or orientation.

Analogously to the previously described embodiments, even in this case the plate-like body 10 comprises a base plate 10A and a cover element 10B coupled together. The inlet 10' and outlet 10" ports of the fluid are obtained in the cover element 10B, preferably on the flanks of the latter.

Differently, the third embodiment comprises distribution means 30 of the fluid interposed between the inlet 12 and outlet 13 manifolds and the heat exchange chamber 14.

In particular, the inlet manifold 12 and the outlet manifold 14 are obtained in the cover element 10B and the heat exchange chamber 14 is placed below them. In other terms, the distribution means 30 of the fluid is interposed between the base plate 10A and the cover element 10B.

As it can be seen in Figures 3A and 3B, said distribution means is preferably shaped like a plate 30 comprising a solid region 31 interrupted by through-openings 32, 33. Said through-openings are positioned at the overlying inlet 12 and outlet 13 manifolds.

The through-openings 32, 33 implement a fluid communication between the manifolds 12, 13 and the heat exchange chamber 14.

The fluid inletting the respective manifold 12 falls in the underlying heat exchange chamber 14 by crossing a first opening 32 of the distribution means 30. Once the fluid has crossed said camera 14 it rises in the outlet manifold 13 by crossing a second distinct opening 33 of said distribution means 30.

For example, the through-openings can include an inlet slot 32 and an outlet slot 33, both preferably with continuous development, associated to the inlet manifold 12 and to the outlet manifold 13, respectively.

Preferably, each one of the through-openings 32, 33 has a development direction orthogonal to the crossing direction *L_{P}* of the liquid phase in the unidirectional circulation means T and/or to the crossing direction F of the fluid in the heat exchange chamber 14. The latter case, however, is not applicable with reference to the embodiment example of Figure 3C, wherein the flow channels 14a are shaped so as to determine a plurality of fluid crossing directions in case incident to each other.

Said through-openings 32, 33 preferably have an extension equal to the extension of the respective manifolds 12, 13 thereto they are associated.

According to an advantageous aspect, the interposition of the distribution means 30 allows to define the flow channels 14a inside the heat exchange chamber 14. In other words, the flow channels 14a result to be closed on the upper portion by a face of said solid region 31 of the plate 30 facing towards the heat exchange chamber 14.

Similarly, the coupling between the distribution means, in particular of a face of the solid region 31 opposite to the above-mentioned one, and the cover element 10B allows to define the chambers of the inlet 12 and outlet 13 manifolds intended to receive the cooling fluid.

### Application examples of the invention

As previously described, the micro-channel exchanger 100 of the invention finds preferred use destination in cooling electronic apparatuses.

An extremely advantageous application provides the implementation of the exchanger of the invention in a thermosyphon system for cooling personal computers and/or data centres. However, this does not exclude that the proposed solution could offer use effectiveness for applications in different systems (thermosyphons for power electronics or pump-based systems).

In fact, a thermosyphon system typically provides a rising duct (*riser*) for the two-phase fluid suffering from pressure drop fluctuations. Moreover, a thermosyphon generally actuates with relatively modest mass flow rates with respect to the heat flows dispensed by the electronic devices, then the instabilities due to the density fluctuations result to be significant. Additional instabilities therefrom this type of cooling systems suffer are due to the fact that a thermosyphon for a data centre typically has many parallelly connected exchangers.

The proposed high-stability solution with the micro-channel exchanger of the invention allows a thermosyphon system to dispose of high values of thermal loads. Moreover, the exchanger of the invention can be easily modified to cooperate with additional known solutions, for example by implementing divergent flow channels and/or inlet expansion vessels.

The example of Figure 4 shows schematically a thermosyphon cooling system (for example for processors) implementing the first or the second embodiment of the exchanger of the invention, in particular as evaporator.

The inlet 10' and outlet 10" ports of the evaporator 100 connect fluidically the latter to a condenser C, for example cooled with a secondary fluid (air or other), through a so-called liquid line (*downcomer*) designated with reference L and a so-called steam line (*riser*) designated with reference G. The steam is generated by means of exchanging the heat produced by the (not shown) computer processing unit. The steam flows by means of the steam line G and condenses in liquid phase in the condenser C. The herein obtained liquid flows by gravity by means of the liquid line L, going back to the evaporator 100 and completing natural circulation.

The example of Figure 5A and 5B shows schematically a thermosyphon cooling system for a data centre 200 implementing the third embodiment of the exchanger of the invention, in particular as evaporator.

The invention results to be particularly advantageous for the data centres since, as it provides the use of many evaporators parallelly, an additional instability may occur due to the flows evaporating parallelly.

With reference to Figure 5A, a condenser C, placed in the upper portion of a *rack* of *server* 201, is connected to the *downcomer L* and to the *riser G.* Both lines are connected parallelly to evaporators 100, as many as the electronic components to be cooled (for example CPU, GPU, *memory card* and the like). The heat generated by the electronic components triggers the evaporation of the cooling fluid inside the evaporators 100.

Due to the density difference, the steam tends to flow upwards by means of the *riser* G. In the condenser C the steam is condensed in a liquid phase by disposing of the accumulated heat towards a secondary fluid (for example water or other heat transfer fluid). The herein obtained liquid flows by gravity by means of the *downcomer* L and crosses again in all evaporators 100 by completing natural circulation.

In the example of Figure 5A the thermosyphon applied to one single *rack* of *server* 201 is shown. However, it is to be noted that each *rack* in the *data centre* 200 could be served by the same cooling system, then each *rack* will be associated to a dedicated thermosyphon. The secondary fluid can dispose of heat with a *chiller,* an external environment (air, aquifer or other), a user for the heat recovery (heating of buildings, electricity production) or other.

The architecture of the connections of the evaporators 100 is shown as a way of example in Figure 5B.

At the level of *server* 201 they are connected parallelly by means of suitable fittings of liquid phase *l* and fittings of steam phase *g* allowing a connection to the *downcomer* G and to the *riser* G. The thermal contact between the evaporators 100 and the electronic components preferably is guaranteed by a thermal interface material (thermal paste, tablets or other).

The present invention has been sofar described with reference to preferred embodiments. It is to be meant that other embodiments belonging to the same inventive core may exist, as defined by the protective scope of the here-below reported claims.

## Claims

1. A micro-channel type evaporator (100) suitable for cooling electronic components, which evaporator (100) comprises a plate-like body (10) having an external coupling surface (11) with the electronic component to be cooled, wherein said plate-like body (10) internally carries an inlet manifold (12) for a two-phase cooling fluid and an outlet manifold (13) for said fluid downstream of the heat exchange, wherein said inlet manifold (12) and said outlet manifold (13) are in fluid communication by means of a heat exchange chamber (14) within said plate-like body (10) at said coupling surface (11) and by means of unidirectional circulation means (T) of the two-phase cooling fluid, **characterised in that** said unidirectional circulation means (T) is housed in said plate-like body (10) and is configured to allow circulation of the liquid phase of the fluid exclusively from said outlet manifold (13) towards said inlet manifold (12).

2. The evaporator (100) according to claim 1, wherein said unidirectional circulation means comprises a Tesla valve (T).

3. The evaporator (100) according to any one of the preceding claims, wherein said unidirectional circulation means (T) is external to said heat exchange chamber (14).

4. The evaporator (100) according to any one of the preceding claims, wherein said plate-like body (10) comprises a base plate (10A) and a cover element (10B) coupled together in such a way as to define first flow channels (14a) for the two-phase cooling fluid carried inside said heat exchange chamber (14).

5. The evaporator (100) according to the preceding claim, wherein said first flow channels (14a) extend along respective prevalent directions of development (S) parallel to each other.

6. The evaporator (100) according to claim 4 or 5, wherein said first flow channels (14a) comprise a metal foam structure or a plurality of ribs made in form of fins (141).

7. The evaporator (100) according to any of the preceding claims, wherein said heat exchange chamber (14) is interposed between said inlet manifold (12) and said outlet manifold (13).

8. The evaporator (100) according to the preceding claim, wherein said unidirectional circulation means (T) comprises second flow channels (Tₐ) for the two-phase cooling fluid external to said heat exchange chamber (14).

9. The evaporator (100) according to any one of the preceding claims, wherein second unidirectional circulation means (T') is housed in the plate-like body (10) and is configured so as to prevent circulation of the two-phase cooling fluid from said inlet manifold (12) towards a corresponding inlet port (10') of the fluid in the evaporator.

10. The evaporator (100) according to any one of claims 1 to 6, wherein said unidirectional circulation means (T) and said heat exchange chamber (14) are superimposed on each other.

11. The evaporator (100) according to the preceding claim, wherein fluid distribution means (30) is interposed between said inlet (12) and outlet (13) manifold and said heat exchange chamber (14).

12. The evaporator (100) according to the preceding claim, wherein said inlet manifold (12) and said outlet manifold (13) are placed at respective openings (32, 33) of said distribution means (30).

13. The evaporator (100) according to any one of the preceding claims, wherein said plate-like body (10) has a substantially quadrilateral geometry and wherein said inlet manifold (12) and said outlet manifold (13) are positioned along opposite perimeter edges of said plate-like body (10).

## Patentansprüche

1. Verdampfer (100) vom Mikrokanaltyp, der zum Kühlen elektronischer Komponenten geeignet ist, wobei der Verdampfer (100) einen plattenartigen Körper (10) mit einer äußeren Kopplungsoberfläche (11) mit der zu kühlenden elektronischen Komponente umfasst, wobei der plattenartige Körper (10) im Inneren einen Einlassverteiler (12) für ein zweiphasiges Kühlfluid und einen Auslassverteiler (13) für das Fluid stromabwärts des Wärmeaustauschs trägt, wobei der Einlassverteiler (12) und der Auslassverteiler (13) mittels einer Wärmeaustauschkammer (14) innerhalb des plattenartigen Körpers (10) an der Kopplungsoberfläche (11) und mittels einer unidirektionalen Zirkulationseinrichtung (T) des zweiphasigen Kühlfluids in Fluidverbindung stehen, **dadurch gekennzeichnet, dass** die unidirektionale Zirkulationseinrichtung (T) in dem plattenartigen Körper (10) untergebracht ist und so konfiguriert ist, dass sie eine Zirkulation der flüssigen Phase des Fluids ausschließlich von dem Auslassverteiler (13) in Richtung des Einlassverteilers (12) ermöglicht.

2. Verdampfer (100) nach Anspruch 1, wobei die unidirektionale Zirkulationseinrichtung ein Tesla-Ventil (T) umfasst.

3. Verdampfer (100) nach einem der vorstehenden Ansprüche, wobei sich die unidirektionale Zirkulationseinrichtung (T) außerhalb der Wärmeaustauschkammer (14) befindet.

4. Verdampfer (100) nach einem der vorstehenden Ansprüche, wobei der plattenartige Körper (10) eine Grundplatte (10A) und ein Abdeckelement (10B) umfasst, die so miteinander verbunden sind, dass sie erste Strömungskanäle (14a) für das in der Wärmeaustauschkammer (14) geführte zweiphasige Kühlfluid definieren.

5. Verdampfer (100) nach dem vorstehenden Anspruch, wobei die ersten Strömungskanäle (14a) entlang jeweiliger vorherrschender Verlaufsrichtungen (S) parallel zueinander verlaufen.

6. Verdampfer (100) nach Anspruch 4 oder 5, wobei die ersten Strömungskanäle (14a) eine Metallschaumstruktur oder eine Vielzahl von Rippen in Form von Lamellen (141) umfassen.

7. Verdampfer (100) nach einem der vorstehenden Ansprüche, wobei die Wärmeaustauschkammer (14) zwischen dem Einlassverteiler (12) und dem Auslassverteiler (13) angeordnet ist.

8. Verdampfer (100) nach dem vorstehenden Anspruch, wobei die unidirektionale Zirkulationseinrichtung (T) zweite Strömungskanäle (Tₐ) für das zweiphasige Kühlfluid außerhalb der Wärmeaustauschkammer (14) umfasst.

9. Verdampfer (100) nach einem der vorstehenden Ansprüche, wobei ein zweites unidirektionales Zirkulationsmittel (T) im plattenartigen Körper (10) untergebracht ist und so konfiguriert ist, dass es eine Zirkulation des zweiphasigen Kühlfluids vom Einlassverteiler (12) zu einer entsprechenden Einlassöffnung (10') des Fluids im Verdampfer verhindert.

10. Verdampfer (100) nach einem der Ansprüche 1 bis 6, wobei die unidirektionale Zirkulationseinrichtung (T) und die Wärmeaustauschkammer (14) übereinander angeordnet sind.

11. Verdampfer (100) nach dem vorstehenden Anspruch, wobei zwischen dem Einlass- (12) und Auslassverteiler (13) und der Wärmeaustauschkammer (14) eine Flüssigkeitsverteilungseinrichtung (30) angeordnet ist.

12. Verdampfer (100) nach dem vorstehenden Anspruch, wobei der Einlassverteiler (12) und der Auslassverteiler (13) an jeweiligen Öffnungen (32, 33) der Verteilungseinrichtung (30) platziert sind.

13. Verdampfer (100) nach einem der vorstehenden Ansprüche, wobei der plattenartige Körper (10) eine im Wesentlichen vierseitige Geometrie aufweist und wobei der Einlassverteiler (12) und der Auslassverteiler (13) entlang gegenüberliegender Umfangskanten des plattenartigen Körpers (10) positioniert sind.

## Revendications

1. Évaporateur (100) de type à microcanaux destiné au refroidissement de composants électroniques, lequel évaporateur (100) comprend un corps en forme de plaque (10) ayant une surface d'accouplement externe (11) avec le composant électronique à refroidir, dans lequel ledit corps en forme de plaque (10) porte à l'intérieur un collecteur d'admission (12) pour un fluide de refroidissement à deux phases et un collecteur de sortie (13) pour ledit fluide en aval de l'échange de chaleur, dans lequel ledit collecteur d'admission (12) et ledit collecteur de sortie (13) sont en communication fluidique au moyen d'une chambre d'échange de chaleur (14) à l'intérieur dudit corps en forme de plaque (10) au niveau de ladite surface d'accouplement (11) et au moyen d'un moyen de circulation unidirectionnel (T) du fluide de refroidissement à deux phases, **caractérisé en ce que** ledit moyen de circulation unidirectionnel (T) est logé dans ledit corps en forme de plaque (10) et est conçu pour permettre la circulation de la phase liquide du fluide exclusivement à partir dudit collecteur de sortie (13) vers ledit collecteur d'admission (12).

2. Évaporateur (100) selon la revendication 1, dans lequel ledit moyen de circulation unidirectionnel comprend une valve de Tesla (T).

3. Évaporateur (100) selon l'une quelconque des revendications précédentes, dans lequel ledit moyen de circulation unidirectionnel (T) est extérieur à ladite chambre d'échange de chaleur (14).

4. Évaporateur (100) selon l'une quelconque des revendications précédentes, dans lequel ledit corps en forme de plaque (10) comprend une plaque de base (10A) et un élément de couverture (10B) accouplés ensemble de manière à définir les premiers canaux d'écoulement (14a) pour le fluide de refroidissement à deux phases transporté à l'intérieur de ladite chambre d'échange de chaleur (14).

5. Évaporateur (100) selon la revendication précédente, dans lequel lesdits premiers canaux d'écoulement (14a) s'étendent le long de directions prévalentes respectives de développement (S) parallèles les unes aux autres.

6. Évaporateur (100) selon la revendication 4 ou 5, dans lequel lesdits premiers canaux d'écoulement (14a) comprennent une structure en mousse métallique ou une pluralité de nervures en forme d'ailettes (141).

7. Évaporateur (100) selon l'une quelconque des revendications précédentes, dans lequel ladite chambre d'échange de chaleur (14) est interposée entre ledit collecteur d'admission (12) et ledit collecteur de sortie (13).

8. Évaporateur (100) selon la revendication précédente, dans lequel ledit moyen de circulation unidirectionnel (T) comprend des seconds canaux d'écoulement (Tₐ) pour le fluide de refroidissement à deux phases extérieur à ladite chambre d'échange de chaleur (14).

9. Évaporateur (100) selon l'une quelconque des revendications précédentes, dans lequel le second moyen de circulation unidirectionnel (T') est logé dans le corps en forme de plaque (10) et est conçu de manière à empêcher la circulation du fluide de refroidissement à deux phases depuis ledit collecteur d'admission (12) vers un orifice d'admission correspondant (10') du fluide dans l'évaporateur.

10. Évaporateur (100) selon l'une quelconque des revendications 1 à 6, dans lequel ledit moyen de circulation unidirectionnel (T) et ladite chambre d'échange de chaleur (14) sont superposés l'un sur l'autre.

11. Évaporateur (100) selon la revendication précédente, dans lequel le moyen de distribution de fluide (30) est interposé entre ledit collecteur d'admission (12) et de sortie (13) et ladite chambre d'échange de chaleur (14).

12. Évaporateur (100) selon la revendication précédente, dans lequel ledit collecteur d'admission (12) et ledit collecteur de sortie (13) sont placés au niveau des ouvertures respectives (32, 33) dudit moyen de distribution (30).

13. Évaporateur (100) selon l'une quelconque des revendications précédentes, dans lequel ledit corps en forme de plaque (10) a une géométrie sensiblement quadrilatérale et dans lequel ledit collecteur d'admission (12) et ledit collecteur de sortie (13) sont positionnés le long des bords périmétriques opposés dudit corps en forme de plaque (10).
